# EUROPÄISCHE PATENTSCHRIFT

(11) **EP 2 151 148 B1**
(45) Veröffentlichungstag und Bekanntmachung des Hinweises auf die Patenterteilung: **10.11.2010**
(21) Anmeldenummer: 08735271.2
(22) Anmeldetag: 16.04.2008
(51) Int. Cl.: H05K 3/00, H01L 23/13, B23K 20/00, G06K 19/077, H01L 25/065

(54) **VERFAHREN ZUR HERSTELLUNG EINER LEITERPLATTE MIT EINER KAVITÄT FÜR DIE INTEGRATION VON BAUTEILEN**
METHOD FOR PRODUCING A CIRCUIT BOARD HAVING A CAVITY FOR THE INTEGRATION OF COMPONENTS
PROCÉDÉ DE PRODUCTION D'UNE PLAQUE DE CIRCUIT IMPRIMÉ POURVUE D'UNE CAVITÉ POUR L'INTÉGRATION DE COMPOSANTS

(30) Priorität: 27.04.2007 DE 102007020475
(43) Veröffentlichungstag der Anmeldung: 10.02.2010
(73) Patentinhaber: Häusermann GmbH, 3571 Gars am Kamp (AT)
(72) Erfinder: JANESCH, Rudolf, A-3571 Gars am Kamp (AT); STRUMMER, Erich, A-3571 Gars am Kamp (AT); HACKL, Johann, A-3571 Gars am Kamp (AT)
(74) Vertreter: Riebling, Peter
(86) Internationale Anmeldenummer: PCT/EP2008/003025
(87) Internationale Veröffentlichungsnummer: WO 2008/135142

(56) Entgegenhaltungen:
- EP-A- 1 041 631
- WO-A-99/09596
- WO-A-2004/062842
- GB-A- 2 302 451
- US-A- 5 780 776
- US-A1- 2007 086 695

## Beschreibung

Gegenstand der Erfindung ist ein Verfahren zur Herstellung einer Leiterplatte, insbesondere eine Leiterplatte mit mehreren Lagen (Multilayer Printed Circuit Board - ML-PCB), wobei zumindest in eine der beiden Oberflächen eine Kavität mittels Fäser gefertigt wird und derart eine Kavität zur Aufnahme eines elektronischen Bauteils in Form eines ungehausten Integrierten Schaltkreises (ICs) oder eines auf Oberflächen montierbaren Bauteils (SMDs - Surface Mount Device) entsteht. Dabei werden zumindest zwei Kontaktelemente einer gewünschten inneren elektrisch leitenden Lage freigelegt und es wird das zumindest eine Bauteil mit den freigelegten Kontaktelementen elektrisch verbunden. Die Montage des Bauteils in der Kavität erfolgt dabei mittels Ultraschall und/oder mit elektrisch leitfähigem Kleber. Durch die Integration von Bauteilen in Kavitäten in Oberflächen von Leiterplatten wird die mögliche Bestückungsfläche auf Leiterplatten erhöht und können derart kostengünstig höher integrierte elektronische Bauteilgruppen hergestellt werden.

In der EP0084249181 wird ein Datenträger wie eine sogenannte Dual-Interface RFID Chipkarte beschrieben. Dabei wird ein laminierter Datenträgerkörper mit einer innenliegenden integrierten Spule aus Silberleitpaste hergestellt und dann wird mittels Stirnfräser eine Kavität gefräst und es werden die zwei Anschlußkontakte zu den Spulenenden hergestellt und danach wird ein Chipmodul eingesetzt. Dabei werden elektrisch leitfähigen Dispenserpunkte auf die Kontaktstellen der Spulenenden angeordnet und anschließend wird das Chipmodul mittels heißschmelzklebefähigen Elementen in die Kavität eingesetzt.

In dieser EP00842491B1 wird das Grundprinzip des Kavitätenfräsens und Einsetzens eines elektronischen Bauteils inklusive der innenliegenden elektrischen Kontaktierung mittels elektrisch leitfähigem Kleber zu einer integrierten Spulenanordung beschrieben und es wird auch das Bauteil weitgehend plan mit der Datenträgeroberfläche angeordnet. Es handelt sich hierbei jedoch nicht um eine Leiterplatte für die Aufnahme von weiteren Bauteilen, die auf der Oberfläche einer Leiterplatte angeordnet werden.

In der WO04062842A1 wird eine Kontaktiermethode (Bonding) eines elektronischen Bauteils, insbesondere eines ungehausten ICs auf ein Substrat mittels Ultraschall genannt. Dabei wird die Temperatur in der Umgebung der Kontaktpartner nicht erhöht. Die Kontaktoberfläche derartiger Bauteile kann dabei aus Nickel oder Nickel-Gold bestehen und die Kontaktstellen auf dem Substrat enthalten ein Metall oder eine Metalllegierung aus der Gruppe Nickel, Aluminium, Kupfer, Gold, Aluminium-Silizium, Aluminium-Kupfer, Aluminium-Silizium-Kupfer und Silber-Blei.

In dieser WO04062842A1 wird das Grundprinzip der Herstellung einer nahezu kalten Kontaktierung mittels Ultraschall und derart der Herstellung intermetallischer Kontakte beschrieben. Ein derartiges Verfahren kann sehr gut bei ICs und SMD-Bauteilen angewendet werden, die Kontaktstellen aufweisen, die geringfügig über die Passivierungsoberfläche hinaus stehen. Es wird jedoch keineswegs ein Verfahren beschrieben, mit dem ein Bauteil in eine Kavität derart integriert wird, dass die Oberflächen weitgehend plan zustande kommen und derart darüber weitere Bauteile im Sinne eines Bestückungsvorganges nach dem Stand der Technik angeordnet werden können.

In der US05963429 beziehungsweise WO09909596A1 wird eine Leiterplatte beschrieben, auf deren Oberfläche eine erste elektronische Komponente in einem Teilbereich dieser Oberfläche montiert wird, die eine Kavität aufweist, in die eine zweite elektronische Komponente montiert ist und wobei die erste elektronische Komponente zumindest in einem Teilbereich über der zweiten elektronischen Komponente montiert ist. Als elektronische Komponenten werden integrierte Schaltkreise (ICs) genannt und als Kontaktiermethoden wird das Drahtbonden als auch das Flip-Chip beziehungsweise das Flip-Tab montieren mittels leitfähigen Tabs genannt.

In dieser US05963429 beziehungsweise WO09909596A1 werden ungehauste ICs mittels IC-Kontaktierungsmethoden in Kavitäten montiert und darüber weitere ICs angeordnet. Eine derartige Leiterplatten-Bestückungstechnologie ist für eine extrem hohe Verpackungsdichte sinnvoll und effizient. Die Bestückungsanlagen müssen allerdings auf die Manipulation von ungehausten ICs ausgelegt sein und müssen bezüglich der Positionsgenauigkeit die kleinen Abstände von Kontaktstellen auf ICs beherrschen. Gegurtete SMD Bauteile erlauben wesentlich größere Toleranzen bei der Bestückung und eine Reparatur beziehungsweise ein Austausch eines fehlerhaften Bauteils ist bei SMD Bauteilen möglich, hingegen bei ungehausten ICs nahezu unmöglich beziehungsweise wirtschaftlich nicht zielführend.

Bei der genannten Druckschrift besteht allerdings der Nachteil, dass sowohl das innere Bauteil (ungehaustes IC) als auch das äußere Bauteil jeweils durch ein Lötverfahren auf der Leiterplatte festgelegt werden.

Das zweimalige Anwenden eines Lötvorganges beeinträchtigt jedoch die Qualität der Lötstellen in entscheidendem Maße.

Würde also zunächst das innere Bauteil in der Kavität durch einen Lötvorgang festgelegt, muss erst ein abdeckendes Harzmittel oder dergleichen in die Kavität eingebracht werden, um das über den Lötvorgang festgelegte Bauteil in der Kavität gegen die Wärmeeinwirkung eines erneuten Lötvorganges zu schützen, der beim Festlegen des über der Kavität angeordneten zweiten Bauteils benötigt wird.

Es ist nie auszuschließen, dass beim Lötvorgang des zweiten Bauteiles, welches auf der Kavität festgelegt wird, auch die Wärme so stark durch das abdeckende Harz hindurchkommt, dass auch die Lötverbindung des in der Kavität ruhenden Ics beeinträchtigt wird.

Ein solches Problem kann nur durch sehr teure und aufwendig einzubringende thermisch ableitende Abdeckharze verhindert werden, was die Herstellungskosten einer solchen Anordnung sehr stark erhöht.

In der US05801438 wird ein Montageverfahren für ein Halbleiterbauelement und ein Multi-Chip-Modul genannt. Dabei wird ein ungehauster IC in einer Kavität eines Substrates mittels Drahtbondtechnik montiert beziehungsweise elektrisch kontaktiert und darüber wird ein SMD Bauteil angeordnet und derart wird ein Multi-Chip-Modul hergestellt. In dieser US05801438 werden also keine SMD Bauteile in Leiterplattenkavitäten angeordnet, sondern ungehauste ICs in Kavitäten mittels Drahtbondtechnik integriert.

Der Stand der Technik umfasst auch die US 2007-0086695.

**Aufgabe** der vorliegenden Erfindung ist die kostengünstige Herstellung von elektronischen Bauteilen in Form einer bestückten Leiterplatte mit der Möglichkeit der Bestückung von möglichst vielen Bauelementen auf einer möglichst kleinen Abmessung der Leiterplatte.

Wesentliches Merkmal der Erfindung ist die Paarung eines thermisch nicht belasteten Kontaktierverfahrens für das in der Kavität angeordnete SMD in Verbindung mit einem thermisch belasteten Lötvorgang für die Festlegung des auf der Kavität ruhenden Bauteils.

Damit wird der wesentliche Fortschritt erzielt, dass die nachträgliche Wärmeeinwirkung beim Anlöten des auf der Kavität liegenden zweiten Bauteils nicht die Kontaktstelle für das in der Kavität angeordnete SMD-Bauteil beeinträchtigt, weil dieses durch ein nichtthermisches Lötverfahren festgelegt ist. Solche nichtthermischen Lötverfahren sind bevorzugt entweder ein Ultraschallschweißen (Reibschweißen) oder auch ein kontaktierendes Kleben.

Damit wird erstmals der Vorteil erreicht, dass beim Auflöten des oberen Bauteils, welches auf der Kavität liegt, die in die Kavität eindringende Wärme nicht mehr die dort angeordnete Kontaktierung in nachteiliger Weise beeinflussen kann.

Es kann deshalb auch auf aufwendige Abdeckmaßnahmen für entsprechende Gießharz verzichtet werden, denn es reicht ein einfaches, kostengünstiges Gießharz, weil die Kavität nach der technischen Lehre der Erfindung nur noch als mechanischer Schutz für das SMD-Bauteil dient, jedoch keinerlei thermische Ableitwirkungen mehr entfalten muss.

Damit werden wesentliche Kosten eingespart.

Die Erfindung bezieht sich demnach auf ein Verfahren gemäß Anspuch 1, zur Herstellung einer Leiterplatte, insbesondere eines Multilayer Printed Circuit Board's, abkürzend mit ML-PCB bezeichnet, wobei zumindest in eine der beiden Oberflächen eine Kavität hergestellt wird und zumindest ein elektronischer Bauteil in Form eines auf Oberflächen montierbaren Bauteils (SMDs - Surface Mount Device) eingesetzt wird. Dabei werden zumindest zwei Kontaktelemente einer gewünschten inneren elektrisch leitenden Lage freigelegt und wird das zumindest eine Bauteil mit den freigelegten Kontaktelementen elektrisch verbunden. Die elektrische Verbindung erfolgt dabei mittels Ultraschall und/oder mittels elektrisch leitfähiger Kleber. Das Bauteil wird bevorzugt vollständig in der Kavität angeordnet, sodass kein Überstand des Bauteils gegeben ist. Derart wird die bestückbare Oberfläche einer Leiterplatte erhöht. Das zumindest eine integrierte Bauteil wird bevorzugt in einem ersten Bestückungsvorgang integriert, kann jedoch ebenso gemeinsam mit dem konventionellen Oberflächenbestückungsvorgang bestückt werden.

In modernen Bohr-Anlagen beziehungsweise Bohr-Fräs-Anlagen kann die z-Achse, also die Tiefe der Kavität auf wenige µm genau vorgewählt werden und kann derart auch eine 9 µm bis 18 µm bis 36 µm dicke Innenlagen aus Kupfer sehr sicher freigelegt werden. In einer weiteren Ausführung der vorliegenden Entwicklung kann die Kavität zur Aufnahme des Bauteils hergestellt werden und können in einem weiteren Prozess die einzelnen elektrischen Anschlüsse freigelegt werden.

In einer bevorzugten Ausführung wird das Bauteil derart in der Kavität angeordnet, dass kein Überstand, also keine Erhöhung der Oberfläche der Leiterplatte, gegeben ist. Derart können in einem weiteren Bestückungsvorgang der Leiterplatte weitere Bauteile auf der Oberfläche und insbesondere auch über das bereits in der Kavität angeordnete Bauteil angeordnet werden und wird dadurch mehr Bestückungsfläche für eine konventionelle Oberflächenbestückung gewonnen und gleichzeitig werden die Verdrahtungslängen reduziert, was für die Erhöhung der Taktfrequenzen positive Auswirkungen mit sich bringt.

Die Prozesse zur Herstellung der zumindest einen Kavität und der diversen elektrischen Anschlußelemente auf der zumindest einen Oberfläche der Leiterplatte werden bevorzugt im Mehrfachnutzen durchgeführt. Im Anschluss an diese Bearbeitung können die freigelegten Kupferoberflächen der elektrischen Anschlußelemente für eine optimale Kontaktierung des einzusetzenden Bauteil beschichtet werden. Dies kann in der einfachsten Art mittels einer OSP (Organic Surface Protection) -Beschichtung erfolgen oder chemisch beziehungsweise galvanisch in der Form von Nickel-Gold oder chemisch Zinn oder chemisch Silber und dergleichen metallischer und/oder organisch leitfähiger polymerer Beschichtungen.

In modernen Mehrfachlagen (Multilayer - ML) - Leiterplattentechnologien werden Bauteile in das Innere einer Leiterplatte integriert. Diese Technologie wird mit "embedded resistor" und "embedded capacitor" und "embedded IC" und "embedded varistor" und "embedded diode" bezeichnet. Dabei erfolgt das "embedding", also die Integration beziehungsweise "Einbettung" derartiger Komponenten im sogenannten Mehrfachnutzen auf Innenlagen eines Multilayer Leiterplattenherstellprozesses nach dem Stand der Technik. Dabei werden konventionelle kleine SMD-Bauteile verwendet als auch spezielle Filmmaterialien beziehungsweise Drucktechniken.

Die integrierten Bauteile müssen dabei üblicherweise auf Innenlagen montiert beziehungsweise kontaktiert werden und müssen dann den üblichen Heiz-Kühl-Transferpressen Laminiervorgang bestehen. Dabei werden Temperaturen von typisch 175°C - 60 Minuten bei üblichen FR-4 Prepregs bis über 200°C und bis über 280°C bei speziellen Laminaten erreicht und zusätzlich werden Flächenpressungen von typisch 14 bis 28 kg/cm² bis über 55 kg/cm² erreicht. Neben der Beständigkeit der Bauteile bei diese hohen Temperaturen und Flächenpressungen über relative lange Laminationszeiten müssen auch die elektrischen Kontakte bei diesen Parametern die volle Funktion beibehalten und muss der Harzfluß derartige Komponenten möglichst ohne Einschlüssen von Luft einbetten.

Eine weitere Variante der Integration von Bauteilen in eine Leiterplatte stellt die Integration von MELF (Metal Electrode Faces) SMD-Bauteilen in Durchsteigelöchern dar. MELF Bauteile werden speziell in der Form eines Widerstandes, einer Dioden, eines Thermistors (PTC, NTC) und dergleichen zylinderförmigen-Bauelement mit zwei Anschlußkontakten an den Stirnflächen mit einem Durchmesser von 1,1 mm bei sogenannten MicroMelf Bauteilen hergestellt. Die MELF Bauform 0201 stellt die vermutlich kleinste Bauformserie mit 0,60 mm Länge und 0,30 mm Durchmesser dar. Die Integration derartiger zylindrischer Bauelemente in Durchsteigelöchern ist heute nur mehr in speziellen Anwendungen gegeben.

In der vorliegenden Erfindung werden Kavitäten im Mehrfachnutzen einer Leiterplatte hergestellt. Bevorzugt werden dabei Stirnfräser in einer Bohrmaschine beziehungsweise einer Bohr-Fräsmaschine mit einer ausreichend guten z-Achsen Steuerung verwendet. Da üblicherweise relative kleine Bauteile verwendet werden, ist ein runder Stirnfräser meist ausreichend und herstellmäßig sehr effizient. In einem Beispiel, das nicht Schutzbereich der Erfindung erthalten ist, können auch ablativ arbeitende Laser verwendet werden, allerdings ist die Verwendung eines derartigen Lasers relativ zeitintensiv und dadurch kostenintensiv.

Die Tiefe der Kavität wird so eingestellt, dass die gewünschte Innenlage freigelegt wird und derart die zumindest zwei Anschlußflächen für das Bauteil freigelegt werden und die Tiefe der Kavität so gewählt wird, dass das Bauteil voll in der Leiterplatte angeordnet wird und derart kein Überstand gegeben ist.

Neben der Art der Herstellung der Kavität mittels Stirnfräser in einem einzigen Vorgang in Form einer runden Kavität kann auch eine rechteckförmige Kavität gefräst werden.

Weiters können bereits bei diesem ersten Fräsvorgang die elektrischen Kontakte auf der Innenlage freigelegt werden. Es kann jedoch auch mit dem ersten Fräsvorgang nur die Kavität hergestellt werden und in einem zweiten Fräsvorgang können dann die Kontakte auf der Innenlage freigelegt werden und es können auch in einem zweiten Fräs vorgang die elektrischen Kontaktflächen der Innenlage am Grund der Kavität erhaben gestaltet werden, also das Isolationsmaterial neben den Kontaktflächen abgetragen werden.

Die freigelegten Kontakte auf der Innenlage können dann noch immer im Mehrfachnutzen mittels OSP (Organic Surface Protection) oder mittels Nickel-Gold oder mittels Chemisch-Zinn oder mittels Chemisch-Silber oder mittels weiteren Schutzschichten der Kupferoberfläche der freigelegten Kontakte der Innenlage beschichtet werden. Dabei kann auch die Kupferoberfläche der Kontakte der Innenlage etwas erhaben gestaltet werden.

Zusätzlich besteht die Möglichkeit, dass in die Leiterplatte thermisch gut ableitende Elemente integriert werden und diese Elemente können dann ebenfalls mit einem Stirnfräser elementweise freigelegt werden und kann dann auf diese freigelegte thermisch gut leitende beziehungsweise ableitende Fläche das Bauteil thermisch gut leitend montiert werden. Insbesondere können derartige thermisch gut leitende und im Inneren einer Leiterplatte angeordneten Elemente mittels Drahtlegetechnik und zumindest flächenweiser Ultraschallschweißung auf Innenlagenleiterbahnstrukturen angeordnet werden. Die thermisch gut leitende Montage kann mittels entsprechender Wärmeleitpasten beziehungsweise thermisch gut leitender Kleber beziehungsweise Pasten durchgeführt werden, als auch mit entsprechenden thermisch gut leitenden Folien.

Der Mehrfachnutzen wird nun in einzelne Bestückungsnutzen getrennt und durchläuft den weiteren Leiterplattenherstellprozess nach dem Stand der Technik, also einer elektrischen Kontrolle beziehungsweise entsprechenden Qualitätskontrolle.

Der Bestückungsnutzen wird dann beim Bestücken zunächst mit den Bauteilen versehen werden, die in die Kavitäten montiert werden sollen. Anschließend werden die üblichen SMD Bauteile 'lead' oder 'leadless', also mit Anschlußbeinchen die nach innen (J-Lead) oder außen gebogen sind beziehungsweise in der Form von Mövenflügeln (Gull-wings) geformt sind beziehungsweise ohne Beinchen (leadless) beziehungsweise in Form von BGAs (Ball-Grid-Arrays) oder SGAs (Solder-Grid-Arrays) montiert. Bauteile mit radialen Anschlußbeinchen, wie Steckerleisten oder große beziehungsweise schwere Bauteile werden meist in ein sogenannten Mischbestückung montiert.

Grundsätzlich können auch die ersten Bauteile, die in einer Kavität angeordnet werden und die zweiten Bauteile, die auf der Oberfläche der Leiterplatte angeordnet werden, in einem Arbeitsgang montiert werden. Da jedoch die ersten montierten Bauteile in einer Kavität bevorzugt noch mit einer Füllmasse (Glob Top) ausgefüllt werden und da der Montagevorgang der ersten Bauteile in der Kavität mittels Ultraschall oder Klebetechnik meist unterschiedlich ist zu dem Bestückungsvorgang der zweiten Bauteile auf der Oberfläche der Leiterplatte, ist ein zweifacher Bestückungsvorgang in den meisten Fällen der effizientere Bestückungsvorgang.

Der Bestückungsvorgang der ersten Bauteile in der Kavität mittels Ultraschall und/oder mittels elektrisch leitfähigem Kleber ist grundsätzlich sehr ähnlich. Bei Verwendung von Ultraschallenergie müssen die Kontaktpartner geringfügig, also um wenige Mikrometer, höher sein, als die umgebende Isolation. Meist ist die Verwendung eines Klebers im Sinne eines sogenannten "Undefillers", also ein sehr dünnflüssiger Klebstoff, von Vorteil. Damit werden kleinste Luftlöcher beziehungsweise Hohlräume ausgefüllt und die Stabilität und Langzeiteigenschaften verbessert. Die Kontaktpartner beim Ultraschallkontaktieren können vielfältig sein. Nahezu alle bekannten metallischen Oberflächen von Bauteilkontakten und Leiterplattenoberflächen sind dabei geeignet. Da der Kontaktiervorgang weitgehend kalt erfolgt, entstehen auch kaum Thermospannungen. Durch den kurzen Ultraschallmontagevorgang werden nur die korrespondierenden Kontaktflächen auf jene Temperatur erhöht, die eine intermetallische Verbindung ermöglichen. Da dieser flächenartige intermetallische Bereich jedoch nur im Mikrometer Bereich liegt, werden die Bauteile und die Innenlagen kaum erwärmt. Die Sonotrode, mit der das Bauteil gehalten und mit der die Ultraschallenergie eingebracht wird, weist ebenfalls keine erhöhte Temperatur auf.

Bei Verwendung von elektrisch leitfähigen Klebern werden aufgrund der Verwendung von SMD-Bauteilen bevorzugt isotrop leitfähige Kleber verwendet. Bei hochdichten Flip-Chip Montagen kann die Verwendung von anisotrop elektrisch leitfähigen Klebern ein Vorteil sein. Die leitfähigen Kleber werden bevorzugt mittels Dispenserapplikation auf die elektrischen Kontakte in der Kavität angeordnet. Dabei können ein- oder zweikomponentige Kleber und Kleber mit UV-und/oder IR und/oder thermischer und/oder Mikrowellen- Härtung verwendet werden.

Es kann auch eine Kombination von mittels Ultraschall und mittels elektrisch leitfähigem Kleber montierten Bauteilen gewählt werden. Üblicherweise werden im Anschluß an die Montage und bevorzugt der Kontrolle der Funktion die Kavität mit dem montierten Bauteil mit einem Harz (Glob Top) ausgefüllt und gehärtet. Diese Einebnung ist für den weiteren Bestückungsvorgang der zweiten Bauteile auf der Oberfläche der Leiterplatte sinnvoll und notwendig, da in nicht ausgefüllte Bereiche der Kavität Flußmittel und gegebenenfalls Lot geraten kann und derart die Funktion der gesamten bestückten Leiterplatte gefährden kann beziehungsweise negative Auswirkungen auf die Langzeitstabilität und Funktion ausüben kann.

Alle in den Unterlagen, einschließlich der Zusammenfassung offenbarten Angaben und Merkmale, insbesondere die in den Zeichnungen dargestellte Ausbildung, werden als erfindungswesentlich beansprucht, soweit sie einzeln oder in Kombination gegenüber dem Stand der Technik neu sind.

Die Erfindung wird nun anhand mehrerer Ausführungsbeispiele näher beschrieben. Hierbei gehen aus den Zeichnungen und ihrer Beschreibung weitere Vorteile und Merkmale hervor.

Dabei zeigt:
Figur 1: einen schematischen Schnitt durch eine ML-Leiterplatte mit einer Kavität mit eingesetztem SMD-Bauteil und darüber angeordnetem SMD-Bauteil,
Figur 2: einen schematischen Schnitt durch eine ML-Leiterplatte mit einer Kavität mit eingesetztem SMD-Bauteil und darüber angeordnetem leadless-SMD-Bauteil,
Figur 3: eine schematische Draufsicht auf eine ML-Leiterplatte mit einer runden Kavität mit eingesetztem SMD-Bauteil mit einer diagonal angeordneten Kontaktierung,
Figur 4: eine schematische Draufsicht auf eine ML-Leiterplatte mit einer runden Kavität mit eingesetztem SMD-Bauteil mit einer seitlich über die Kanten angeordneten Kontaktierung,
Figur 5: eine schematische Draufsicht auf eine ML-Leiterplatte mit einer runden Kavität mit eingesetztem SMD-Bauteil mit Mehrfachkontaktierungen an allen vier Kanten.

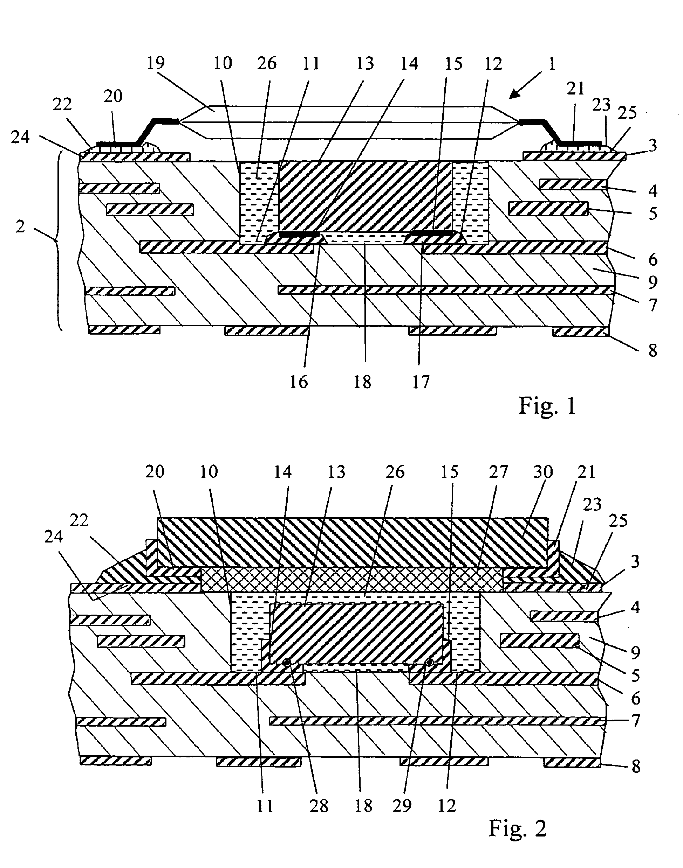

In **Figur 1** ist ein schematischer Schnitt durch eine Leiterplatte (1) bestehend aus einer ML-Leiterplatte (2) mit einer Kavität (10) mit eingesetztem SMD-Bauteil (13) und darüber angeordnetem SMD-Bauteil (19) dargestellt.

Die Leiterplatte (2) weist in dieser Ausführungsvariante eine oben und unten liegende Leiterbahnstruktur (3, 8) auf und vier Innenlagenleiterbahnstrukturen (4, 5, 6, 7). Die Harzmatrix (9) wird durch die diversen Harzschichten der einzelnen Innenlagen gebildet und besteht beispielhaft bei Verwendung von FR-4 Material aus einem Glasfasergewebe-Epoxidharz-System oder bei Verwendung von FR-2 Material aus einem Phenolharzhartpapier-System und kann grundsätzlich aus allen nach dem Stand der Technik in der Leiterplattenindustrie bekannten Systemen bis zu CEM-1 bis 3 oder Aramid oder Polyimid Folien Systemen nach dem Stand der Technik gebildet werden. Darüber hinaus kann zusätzlich zu einer der Innenlagen (4, 5, 6, 7) mittels Ultraschall-Drahtlegetechnik noch ein thermisch und elektrisch gut leitendes Element, bevorzugt aus Kupferdraht beziehungsweise Kupferflachband integriert werden und kann damit eine Erhöhung der Wärmeableitung beziehungsweise kann damit eine höhere Stromleitung erzielt werden.

Leiterplattenbohrmaschinen beziehungsweise Fräsmaschinen können mittels spezieller Stirnfräswerkzeugen und einer exakten Tiefenkontrolle (z-Achsenkontrolle) sehr präzise Kavitäten (10) herstellen. Dabei ist eine z-Achsen Tiefenkontrolle auf einige µm möglich, wobei übliche Kupferdicken im Bereich größer 9 µm und typisch bei 35 µm liegen und derart die Freilegung von Kontaktflächen (11, 12) sehr sicher erfolgen kann. Das Fräswerkzeug kann dabei in einem Arbeitsvorgang eine runde Kavität (10) mit dem Durchmesser des Stirnfräsers bewirken. Bei Verwendung eines kleineren Durchmessers kann mittels Konturfräsen nahezu jede beliebig geformte Kavität (10) fräsen, wobei die Kanten üblicherweise mit dem Radius des Fräswerkzeuges ausgebildet werden.

Die Herstellung der Kavität (10) und der flächigen Kontakte (11, 12) kann in einem Arbeitsvorgang erfolgen oder in zwei Arbeitsvorgängen, wobei im zweiten Fall die Kavität (10) in der gewünschten Tiefe hergestellt wird und dann die Kontaktflächen (11, 12) freigelegt werden. Dabei können die Kontaktflächen (11, 12) rund mit einem Stirnfräser mit geeignetem Durchmesser ausgeführt werden oder es kann die gewünschte Fläche freigefräst werden.

Im Anschluß an die Herstellung der zumindest einen Kavität (10) und der zumindest zwei Kontaktflächen (11, 12) kann die Leiterplatte (2) im Mehrfachnutzen noch einem Kupferflächen Behandlungsprozess unterzogen werden. Dabei können die Kupferkontaktflächen (11, 12) gegen Oxidation geschützt werden beziehungsweise kann eine Beschichtung ausgeführt werden, die beim Kontaktieren eines Bauteils (13) hilfreich ist. Die Kupferbehandlung beziehungsweise -beschichtung erfolgt derart nach dem Stand der Technik mittels OSP (Organic Surface Protection) oder mittels lötbarem bleifreiem Zinn oder mittels chemisch Zinn oder Nickel oder Silber oder Gold beziehungsweise mit Schichtkombinationen, wie Ni-Au und dergleichen passivierenden Oberflächen.

Die Leiterplatte im Herstell-Mehrfachnutzen wird anschließend in den Bestückungsnutzen geteilt. Die Bestückungsnutzen können aus einer einzelnen Leiterplatte gebildet werden oder es können mehrere zusammengefasst verwendet werden. Speziell bei kleinen geometrischen Abmessungen einer Leiterplatte werden die Bestückungsnutzen aus mehreren Leiterplatten gebildet. In dieser ersten aufgezeigten Ausführungsform wird ein Bauteil (13) mit seinen Kontaktelementen (14, 15) mittels elektrisch leitfähigem Kleber (16, 17) mit den Kontaktflächen (11, 12) verbunden. Dabei wird üblicherweise mittels Dispenser der leitfähige Kleber (16, 17) beziehungsweise die elektrisch leitfähige Paste auf die Kontaktflächen (11, 12) appliziert und anschließend wird das Bauteil (13) eingesetzt. Der elektrisch leitfähige Kleber (16, 17) wird anschließend nach dem Stand der Technik chemisch (2-komponentige Kleber bzw. Pasten) und/oder thermisch und/oder strahlentechnisch und/oder mit Mikrowellenenergie unter einer gewissen Druckaufbringung gehärtet. Oftmals wird zusätzlich ein sogenannter Underfiller (18) verwendet. Damit soll die mechanische Haftung des Bauteils (13) in der Kavität (10) verbessert werden und es sollen üblicherweise Lufteinschlüsse vermieden werden, da diese ungünstige Lebensdauerlangzeiteffekte mit sich bringen können. Zusätzlich kann noch ein kompletter Verguß (26) ausgeführt werden, wobei der Verguß (26) und der Unterfüllvorgang (18) auch in einem Prozess und mit ein und demselben Material erfolgen kann. Durch die Ausfüllung (16) der Kavität kann bei einem späteren Lötvorgang weder Flußmittel noch Zinn in einzelne Bereiche der Kavität gelangen.

Die Oberfläche der Leiterplatte (2) im Bereich des Bauteils (13) und der Vergußmasse (26) kann zusätzlich noch mit einer Art Lötstopplack versehen werden.

Die Leiterplatte (2) mit dem integrierten Bauteil (13) kann nunmehr einem konventionellen Bestückungsprozess unterzogen werden. Dabei kann ein Bauteil (19) über dem Bauteil (13) angeordnet werden und können die Bauteilkontaktelemente (20, 21) mit Lötkontakten (22, 23) auf den Kontaktelementen (24, 25) kontaktiert werden und wird derart Leiterplattenoberfläche für die Oberflächenbestückung gewonnen werden.

In **Figur 2** wird ein schematischer Schnitt durch eine ML-Leiterplatte (2) mit einer Kavität (10) mit eingesetztem SMD-Bauteil (13) und darüber angeordnetem leadless-SMD-Bauteil (3) dargestellt. In dieser Ausführungsform werden die Bauteilkontakte (14, 15) des Bauteils (13) mittels Ultraschallenergie mit den Kontaktflächen (11, 12) intermetallisch verbunden. Die Ultraschallbondtechnik ist eine altbewährte Verbindungstechnik und stellt eine nahezu kalte Kontaktiermethode dar. Es wird das Bauteil (13) von einer Ultraschall-Sonotrode mit Druck und Schallenergie von einigen 20 kHz bis in den Bereich 60 kHz und darüber auf die Kontaktflächen (11, 12) gedrückt. Das Bauteil (13) wird dabei praktisch nicht erwärmt. Dadurch werden auch keine Thermospannungen im intermetallischen flächigen Kontaktbereich (28, 29) eingebaut. Das Unterfüllharz (18) beziehungsweise die Vergußmasse (26) können in Analogie zu Figur 1 angewendet werden.

Auf die Leiterplatte (2) mit fertig integriertem Bauteil (13) wird in dieser Ausführungsform ein beinchenloser (lead-less) SMD Bauteil (30) angeordnet. Dabei wird das SMD Bauteil mittels bekannter Techniken mit einer Haftschicht (27) auf der Oberfläche der Leiterplatte (2) befestigt und die Bauteilkontakte (20, 21) des SMD Bauteils (30) werden nach dem Stand der Löttechnik mit Lot (22, 23) auf den Kontaktflächen (24, 25) kontaktiert.

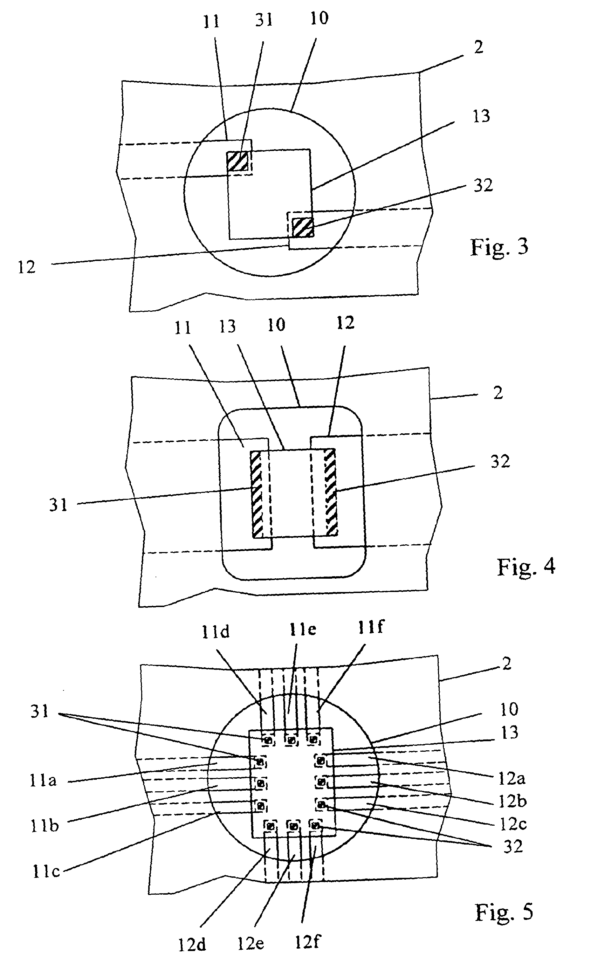

In **Figur 3** wird eine schematische Draufsicht auf eine ML-Leiterplatte (2) mit einer runden Kavität (10) mit eingesetztem SMD-Bauteil (13) mit einer diagonal angeordneten Kontaktierung (31, 32) aufgezeigt. In dieser Ausführung ist ein kleiner Bauteil (13) mit nur zwei Kontaktflächen (31, 32) dargestellt. Dabei kann ein einfacher Stirnfräser mit dem Radius der Kavität (10) in einem Fräsvorgang die Kavität (10) herstellen und die Kontaktflächen (11, 12) freilegen. Wie bereits in der Beschreibung in Figur 1 aufgezeigt, kann auch ein zweiter Fräs vorgang zur Freilegung der Kontakte (11, 12) durchführen. In diesem zweiten Fall würden dann die Kontaktflächen (11, 12) zumindest in dem Bereich der Kontaktflächen (31, 32) des Bauteils freigelegt werden und das Niveau der Kontakte (11, 12) und der Bauteilkontakte (31, 32) kann im Fall der Verwendung von elektrisch leitfähigen Klebern beziehungsweise Pasten in der z-Ache beabstandet ausgeführt sein. Bei Verwendung der Ultraschalltechnik müssen die Kontaktebenen derart ausgeführt sein, dass zumindest einige wenige Mikrometer Erhabenheit gegeben ist.

In **Figur 4** wird eine schematische Draufsicht auf eine ML-Leiterplatte (2) mit einer rechteckiger Kavität mit abgerundeten Ecken (10) mit eingesetztem SMD-Bauteil (13) mit einer seitlich über die Kanten angeordneten Kontaktierung (31, 32) aufgezeigt. In dieser Ausführungsvariante wird ein Stirnfräser mit einem kleinen Radius gewählt und wird die Kavität in der Form eines Rechteckes gefräst. Die Ecken des Rechteckes werden üblicherweise den Radius des Fräswerkzeuges aufweisen.

In **Figur 5** wird eine schematische Draufsicht auf eine ML-Leiterplatte (2) mit einer runden Kavität (10) mit eingesetztem SMD-Bauteil (13) mit Mehrfachkontaktierungen (31 a bis f, 32 a bis f) an allen vier Kanten aufgezeigt. Diese Darstellung soll die Vielfalt an Bauteilen (13) aufzeigen, die in eine Kavität (10) eingesetzt und elektrisch kontaktiert werden können.

### Bezugszeichenliste

- 1: Leiterplatte mit zumindest einer Innenlage und zumindest einer Kavität und zumindest einem elektronischen Bauteil
- 2: Leiterplatte: mit zumindest einer Innenlage und zumindest einer Kavität
- 3: Leiterbahnstruktur auf der Oberseite der Leiterplatte
- 4: Erste Innenlagenleiterbahnstruktur
- 5: Zweite Innenlagenleiterbahnstruktur
- 6: Dritte Innenlagenleiterbahnstruktur
- 7: Vierte Innenlagenleiterbahnstruktur
- 8: Leiterbahnstruktur auf der Unterseite der Leiterplatte
- 9: Harzmatrix: diese Benennung ist nur symbolisch, da die einzelnen Harzlagen zwischen den Innenlagenleiterbahnstrukturen durch den Laminationsprozess miteinander verbunden werden.
- 10: Kavität
- 11: Kontaktfläche beziehungsweise eine Mehrzahl an Kontaktflächen links beziehungsweise oben in der Kavität auf der Innenlagenleiterbahnstruktur 6
- 12: Kontaktfläche beziehungsweise eine Mehrzahl an Kontaktflächen rechts beziehungsweise unten in der Kavität auf der Innenlagenleiterbahnstruktur 6
- 13: Bauteil: eingesetzt in die Kavität
- 14: Kontaktelement des Bauteils links
- 15: Kontaktelement des Bauteils rechts
- 16: Elektrisch leitfähiger Kleber links
- 17: Elektrisch leitfähiger Kleber rechts
- 18: Haftverbundpolymer: sog. 'Underfiller'
- 19: Bauteil: konventionell aufgesetzt auf die Leiterplatte
- 20: Bauteilkontaktelement links
- 21: Bauteilkontaktelement rechts
- 22: Lötkontakt links
- 23: Lötkontakt rechts
- 24: Kontaktelement links auf der Leiterbahnstruktur auf der Oberseite der Leiterplatte
- 25: Kontaktelement rechts auf der Leiterbahnstruktur auf der Oberseite der Leiterplatte
- 26: Polymerer Füllstoff bzw. Vergußmasse
- 27: Haftschicht: zum Fixieren des Bauteils 19 vor dem Lötprozess; Aufbringung mittels Schablonendruck, Siebdruck, Dispenserapplikation u.dgln.
- 28: Ultraschallkontakt links
- 29: Ultraschallkontakt rechts
- 30: Leadless (beinchenloser) SMD Bauteil
- 31: Elektrische Kontaktierung beziehungsweise Bauteilkontaktfläche
- 32: Elektrische Kontaktierung beziehungsweise Bauteilkontaktfläche

## Patentansprüche

1. Verfahren zur Herstellung einer Leiterplatte (1, 2) mit zumindest einer Innenlage (4-7) und zumindest einer Kavität (10) in zumindest einer der beiden Oberflächen für die Aufnahme von zumindest einem ersten elektronischen Bauteil (13), wobei die Kavität (10) nach oben durch ein aufgelötetes zweites Bauteil (30) mindestens teilweise abgedeckt ist und wobei das erste Bauteil (13) in der Kavität (10) mit zumindest zwei elektrischen Kontakten (14, 15) mit korrespondierenden elektrischen Kontakten (16, 17; 28, 29) der Innenlage (4-7) der Leiterplatte (1, 2) verbunden wird, wobei diese elektrischen Kontakte (16, 17; 28, 29) durch ein nicht-thermisches Kontaktierverfahren hergestellt werden, **dadurch gekennzeichnet, dass** die Kavität (10) mittels Fräser in die Oberfläche der Leiterplatte (1, 2) hergestellt wird und dabei zumindest zwei elektrische Anschlußelemente (11, 12) einer Innenlage (4-7) der Leiterplatte (1, 2) freigelegt werden, wobei die elektrischen Anschlußelemente (11, 12) in einem Arbeitsprozess mit der Herstellung der Kavität (10) hergestellt werden oder in einem zweiten Arbeitsprozess lokal begrenzt auf die elektrischen Anschlußelemente (11, 12) hergestellt werden.

2. Verfahren nach Anspruch 1, **dadurch gekennzeichnet, dass** das nichtthermische Kontaktierverfahren der elektrischen Kontakte (28, 29) eine Ultraschall-Verschweißung ist.

3. Verfahren nach Anspruch 1, **dadurch gekennzeichnet, dass** das nichtthermische Kontaktierverfahren der elektrischen Kontakte (16, 17) durch Aufbringen eines elektrisch leitfähigen Klebers erfolgt.

4. Verfahren zur Herstellung einer Leiterplatte nach einem der Ansprüche 1 bis 3, **dadurch gekennzeichnet, dass** das in der Kavität (10) angeordnete Bauteil (13) ein auf Oberflächen montierbarer Bauteil (SMDs - Surface Mount Device) ist und dass die Leiterplatte (1, 2) ein Multilayer mit vier oder mehr Lagen (3-8) ist.

5. Verfahren zur Herstellung einer Leiterplatte nach Anspruch 1-4, **dadurch gekennzeichnet, dass** die zumindest zwei freigelegten elektrischen Anschlußelemente (11, 12) auf einer Innenlage (4-7) der Leiterplatte (1, 2) mittels OSP (Organic Surface Protection) oder mittels Nickel-Gold oder mittel Chemisch-Zinn oder mittels Chemisch-Silber beschichtet werden.

6. Verfahren zur Herstellung einer Leiterplatte nach einem der Ansprüche 1 bis 5, **dadurch gekennzeichnet, dass** die Herstellung der elektrischen Kontakte (28, 29) durch die Beaufschlagung der zu integrierenden Komponente (14, 15) mit Ultraschall erfolgt und derart intermetallische Verbindungskontakte gegeben sind und die Kavität (10) mit dem Bauteil (13) mit einem isolierenden Harz (9) ausgefüllt wird (Underfiller).

7. Verfahren zur Herstellung einer Leiterplatte nach einem der Ansprüche 1 bis 6, **dadurch gekennzeichnet, dass** die Herstellung der elektrischen Kontakte (16, 17) durch die Anordnung von elektrisch leitfähigen polymeren Klebern zwischen den korrespondierenden Kontaktelementen (14, 15; 4-7) erfolgt und die Kavität (10) mit dem Bauteil (13) mit einem Isolierenden Harz (9) ausgefüllt wird (Underfiller).

8. Verfahren zur Herstellung einer Leiterplatte nach einem der Ansprüche 1 bis 7, **dadurch gekennzeichnet, dass** die Bestückung und Kontaktierung des zumindest einen Bauteils (13) in der Kavität (10) in einem ersten Bestückungsvorgang erfolgt und in einem weiteren Bestückungsvorgang eine konventionelle SMD-Bestückung (30) durchgeführt wird und dabei die elektrische Kontaktierung des zuerst montierten Bauteils (13) nicht beeinträchtigt wird.

9. Verfahren zur Herstellung einer Leiterplatte nach einem der Ansprüche 1 bis 7, **dadurch gekennzeichnet, dass** die Bestückung und Kontaktierung des zumindest einen Bauteils (13) in der Kavität (10) gemeinsam mit der konventionellen SMD-Bestückung (30) erfolgt.

## Claims

1. Method for producing a circuit board (1, 2) with at least one inner layer (4 to 7) and at least one cavity (10) in at least one of the two surfaces to receive at least one first electronic component (13), the cavity (10) being at least partially covered toward the top by a soldered-on second component (30) and the first component (13) in the cavity (10) with at least two electrical contacts (14, 15) being connected to corresponding electrical contacts (16, 17; 28, 29) of the inner layer (4 to 7) of the circuit board (1, 2), these electrical contacts (16, 17; 28, 29) being produced by a non-thermal contacting method, **characterised in that** the cavity (10) is produced by means of milling cutters in the surface of the circuit board (1, 2) and in the process at least two electrical connection elements (11, 12) of an inner layer (4 to 7) of the circuit board (1, 2) are exposed, the electrical connection elements (11, 12) being produced in one working process with the production of the cavity (10) or being produced in a second working process locally limited to the electrical connection elements (11, 12).

2. Method according to claim 1, **characterised in that** the non-thermal contacting method of the electrical contacts (28, 29) is an ultrasonic welding.

3. Method according to claim 1, **characterised in that** the noon-thermal contacting method of the electrical contacts (16, 17) takes place by applying an electrically conductive adhesive.

4. Method for producing a circuit board according to any one of claims 1 to 3, **characterised in that** the component (13) arranged in the cavity (10) is a component which can be mounted on surfaces (SMD - Surface Mount Device) and **in that** the circuit board (1, 2) is a multi-layer with four or more layers (3 to 8).

5. Method for producing a circuit board according to claim 1 to 4, **characterised in that** the at least two exposed electrical connection elements (11, 12) are coated on an inner layer (4 to 7) of the circuit board (1, 2) by means of OSP (Organic Surface Protection) or by means of nickel-gold or by means of chemical tin or chemical silver.

6. Method for producing a circuit board according to any one of claims 1 to 5, **characterised in that** the electrical contacts (28, 29) are produced by acting on the components (14, 15) to be integrated with ultrasound and intermetallic connecting contacts are thus provided and the cavity (10) with the component (13) is filled with an insulating resin (9) (underfiller).

7. Method for producing a circuit board according to any one of claims 1 to 6, **characterised in that** the electrical contacts (16, 17) are produced by the arrangement of electrically conductive polymeric adhesives between the corresponding contact elements (14, 15; 4 to 7) and the cavity (10) with the component (13) is filled with an insulating resin (9) (underfiller).

8. Method for producing a circuit board according to any one of claims 1 to 7, **characterised in that** the assembly and contacting of the at least one component (13) in the cavity (10) takes place in a first assembly process and a conventional SMD assembly (30) is carried out in a further assembly process and the electrical contacting of the firstly mounted component (13) is not impaired in the process.

9. Method for producing a circuit board according to any one of claims 1 to 7, **characterised in that** the assembly and contacting of the at least one component (13) in the cavity (10) takes place together with the conventional SMD assembly (30).

## Revendications

1. Procédé pour fabriquer une carte imprimée (1, 2) avec au moins une couche intérieure (4-7) et au moins une cavité (10) dans l'une au moins des deux surfaces, pour recevoir au moins un premier composant électronique (13), étant précisé que la cavité (10) est au moins partiellement couverte, vers le haut, par un second composant (30) brasé et que le premier composant (13) dans la cavité (10) est relié avec au moins deux contacts électriques (14, 15) ) des contacts électriques correspondants (16, 17 ; 28, 29) de la couche intérieure (4-7) de la carte imprimée (1, 2), ces contacts électriques (16, 17 ; 28, 29) étant fabriqués à l'aide d'un procédé de soudure de connexions non thermique, **caractérisé en ce que** la cavité (10) est réalisée à l'aide de fraises dans la surface de la carte imprimée et au moins deux éléments de connexion (11, 12) d'une couche intérieure (4-7) de la carte imprimée (1, 2) étant dégagées, étant précisé que les éléments de connexion électriques (11, 12) sont réalisés lors de la même opération que la réalisation de la cavité (10) ou sont réalisés lors d'une seconde opération, en étant limités localement aux éléments de connexion électriques (11, 12).

2. Procédé selon la revendication 1, **caractérisé en ce que** le procédé de soudure de connexions non thermique des contacts électriques (28, 29) consiste en un soudage aux ultrasons.

3. Procédé selon la revendication 1, **caractérisé en ce que** la soudure de connexions non thermique des contacts électriques (16, 17) se fait grâce à l'application d'une colle conductrice d'électricité.

4. Procédé pour fabriquer une carte imprimée selon l'une des revendications 1 à 3, **caractérisé en ce que** le composant (13) disposé dans la cavité (10) est un composant apte à être monté sur des surfaces (SMD : dispositif monté en surface) et **en ce que** la carte imprimée (1, 2) est un dispositif multicouche avec quatre couches (3-8) ou plus.

5. Procédé pour fabriquer une carte imprimée selon les revendications 1 à 4, **caractérisé en ce que** les deux éléments de connexion électriques dégagés (11, 12), ou plus, prévus sur une couche intérieure (4-7) de la carte imprimée (1, 2) sont revêtus par OSP (Protection de surface organique) ou à l'aide de nickel-or ou d'étain chimique ou d'argent chimique.

6. Procédé pour fabriquer une carte imprimée selon l'une des revendications 1 à 5, **caractérisé en ce qu'**on fabrique les contacts électriques (28, 29) en sollicitant les composants à intégrer (14, 15) à l'aide d'ultrasons, ce qui donne des contacts de liaison intermétalliques, et on remplit la cavité (10) avec le composant (14) de résine isolante (9) (Underfiller).

7. Procédé pour fabriquer une carte imprimée selon l'une des revendications 1 à 6, **caractérisé en ce qu'**on fabrique les contacts électriques (16, 17) en disposant entre les éléments de contact correspondants (14, 15 ; 4-7) des colles polymères conductrices d'électricité, et on remplit la cavité (10) avec le composant (13) de résine isolante (9).

8. Procédé pour fabriquer une carte imprimée selon l'une des revendications 1 à 7, **caractérisé en ce que** le montage et la soudure des connexions du ou des composants (13) dans la cavité (10) se font lors d'une première opération de montage, et un montage SMD classique (30) est réalisé lors d'une autre opération de montage, la soudure des connexions électriques du composant (13) monté en premier n'étant pas altérée.

9. Procédé pour fabriquer une carte imprimée selon l'une des revendications 1 à 7, **caractérisé en ce que** le montage et la soudure des connexions du ou des composants (13) dans la cavité (10) se font conjointement avec le montage SMD classique (30).
